# EUROPEAN PATENT APPLICATION

(11) **EP 4 368 316 A1**
(43) Date of publication of application: **15.05.2024**
(21) Application number: 22837644.8
(22) Date of filing: 04.07.2022
(51) Int. Cl.: B22F 9/00, B22F 1/00, B22F 7/08, H01L 21/52

(54) **METAL PASTE FOR BONDING, AND BONDED BODY AND METHOD FOR PRODUCING SAME**

(30) Priority: 06.07.2021 JP 2021112206
(71) Applicant: Resonac Corporation, Tokyo 105-7325 (JP)
(72) Inventor: NAKAKO, Hideo, Tokyo 100-6606 (JP); EJIRI, Yoshinori, Tokyo 100-6606 (JP); TANAKA, Toshiaki, Tokyo 100-6606 (JP); ISHIKAWA, Dai, Tokyo 100-6606 (JP); NATORI, Michiko, Tokyo 100-6606 (JP)
(74) Representative: Kraus & Lederer PartGmbB
(86) International application number: PCT/JP2022/026607
(87) International publication number: WO 2023/282229

(57) **Abstract**

A metal paste for bonding contains metal particles, a dispersion medium, and a sintering accelerator, the metal particles contain copper particles, the sintering accelerator includes a coordinating compound having electron back donation properties, and the coordinating compound is at least one type selected from the group consisting of a nitrogen-containing aromatic heterocyclic compound, an acetylene derivative, an ethylene derivative, an organic arsenic compound, and a cyanide.

## Description

### Technical Field

The present invention relates to a metal paste for bonding, and a bonded body and a method for producing the same.

### Background Art

When producing a semiconductor device, various bonding materials are used to form a bonding layer for bonding a semiconductor element and a lead frame or the like (a support member). For example, in the bonding of a power semiconductor, LSI, or the like, which is operated at a temperature up to approximately 150°C, a high-lead solder has been used to form a bonding layer. Recently, as higher capacity and space saving of a semiconductor element have progressed, there has been an increasing demand for operating a semiconductor at a high temperature of 175°C or higher. In order to ensure the operational stability of such a semiconductor device, the bonding layer is required to have connection reliability and high thermal conduction properties. However, since the bonding layer of the high-lead solder that has been used in the related art has a problem on the connection reliability and also has an insufficient thermal conductivity (30 Wm⁻¹K⁻¹), in a temperature range of 175°C or higher, a substitutional material is required.

As one substitutional material, a sintered silver layer formed by the sintering phenomenon of silver particles has been proposed (refer to Patent Literature 1 described below). The sintered silver layer has attracted attention since it has been reported that the sintered silver layer has a high thermal conductivity (> 100 Wm⁻¹K⁻¹) and has high connection reliability for a power cycle (refer to Non Patent Literature 1 described below). However, in order to ensure the connection reliability, a thermal compression bonding process accompanied by high pressurization is essential to improve the density of the sintered silver layer, and there are problems such as a damage to a semiconductor element chip and a decrease in the throughput of the thermal compression bonding step. There is another problem that silver has a high material cost.

As another substitutional material, a sintered copper layer using copper has been proposed. Copper is more excellent in a mechanical strength than silver, is likely to obtain high temperature reliability without increasing the density as high as that of the sintered silver layer, and has a material cost that can be kept low. As such a sintered copper layer, a sintered copper layer obtained by reducing and sintering copper oxide particles has been proposed (refer to Patent Literature 2 and Non Patent Literature 2 described below).

### Citation List

### Patent Literature

Patent Literature 1: Japanese Patent No. 4247800
Patent Literature 2: Japanese Patent No. 5006081

### Non Patent Literature

Non Patent Literature 1: R. Khazaka, L. Mendizabal, D. Henry: J. ElecTron. Mater, 43(7), 2014, 2459-2466
Non Patent Literature 2: T. Morita, Y. Yasuda: Materials Transactions, 56(6), 2015, 878-882

### Summary of Invention

### Technical Problem

It is desirable that a member such as a LED chip and a GaN on Si chip does not receive a pressure other than the weight of the member or the weight of a weight used to prevent chip inclination or reduce voids when bonded. However, in order to form sintered copper having a sufficient bonding strength in such a non-pressure condition, it is necessary to reduce and sinter the copper oxide particles in a hydrogen atmosphere, and in a case where a hydrogen concentration exceeds 10%, there may be a restriction such as making the equipment used explosion-proof.

Therefore, an object of the present invention is to provide a metal paste for bonding and a method for producing a bonded body in which a bonded body having a sufficient bonding strength can be obtained even when bonded in a non-pressure condition in an atmosphere not containing hydrogen or having a low hydrogen concentration.

### Solution to Problem

One aspect of the present invention provides a metal paste for bonding, containing: metal particles; a dispersion medium; and a sintering accelerator, in which the metal particles contain copper particles, and the sintering accelerator includes a coordinating compound having electron back donation properties, and the coordinating compound is at least one type selected from the group consisting of a nitrogen-containing aromatic heterocyclic compound, an acetylene derivative, an ethylene derivative, an organic arsenic compound, and a cyanide.

According to the metal paste for bonding described above, even in a case where the members are bonded in a non-pressure condition in an atmosphere not containing hydrogen or having a low hydrogen concentration, a sufficient bonding strength can be obtained.

Note that, in this specification, "non-pressure" indicates a state where a copper paste for bonding receives only the weight of the member bonded, or in addition to the weight, the weight (a pressure of 0.01 MPa or less in terms of pressure) of a weight used to prevent chip inclination or reduce voids.

The coordinating compound may have a lone electron pair and an empty π-electron orbit.

The coordinating compound may be at least one type selected from the group consisting of 2,2'-bipyridyl, 1,10-phenanthroline, 1-ethyl imidazole, 3,6-dichloropyridazine, and 2-cyanopyrimidine.

A content of the sintering accelerator may be 0.01 parts by mass or more and 10 parts by mass or less with respect to a total mass of 100 parts by mass of the copper particles.

The copper particles may contain submicro-copper particles having a volume average particle size of 0.15 µm or more and 0.8 µm or less, and micro-copper particles having a volume average particle size of 2 µm or more and 50 µm or less, a sum of a content of the submicro-copper particles and a content of the micro-copper particles in the metal paste for bonding may be 80% by mass or more, on the basis of a total mass of the metal particles, and the content of the submicro-copper particles in the metal paste for bonding may be 30% by mass or more and 90% by mass or less, on the basis of a sum of a mass of the submicro-copper particles and a mass of the micro-copper particles.

The micro-copper particles may be in the shape of a flake.

In one aspect, the metal paste for bonding may further contain a reductant.

Another aspect of the present invention provides a method for producing a bonded body, including: a step of preparing a laminated body in which a first member, the metal paste for bonding according to one aspect of the present invention, and a second member are laminated in this order; and a sintering step of sintering the metal paste for bonding in the laminated body.

According to the method for producing a bonded body described above, even in a case where in the sintering step, the metal paste for bonding is sintered in a non-pressure condition in an atmosphere not containing hydrogen or having a low hydrogen concentration, a bonded body having a sufficient bonding strength can be obtained.

The sintering step may be a step of sintering the metal paste for bonding in a non-pressure condition in an oxygen-free atmosphere.

At least one of the first member and the second member may be a semiconductor element.

Another aspect of the present invention provides a method for producing a bonded body, including: a step of preparing a laminated body in which a first member, a metal paste for bonding containing metal particles and a dispersion medium, and a second member are laminated in this order; and a sintering step of sintering the metal paste for bonding in the laminated body in the presence of a sintering accelerator, in which the metal particles contain copper particles, and the sintering accelerator includes a coordinating compound having electron back donation properties, and the coordinating compound is at least one type selected from the group consisting of carbon monoxide, ethylene, nitrogen monoxide, and hydrogen cyanide.

According to the method for producing a bonded body described above, even in a case where in the sintering step, the metal paste for bonding is sintered in a non-pressure condition in an atmosphere not containing hydrogen or having a low hydrogen concentration, a bonded body having a sufficient bonding strength can be obtained.

The sintering step may be a step of sintering the metal paste for bonding in a non-pressure condition in an oxygen-free atmosphere.

The metal paste for bonding may further contain a reductant.

In the metal paste for bonding, the copper particles may contain submicro-copper particles having a volume average particle size of 0.15 µm or more and 0.8 µm or less, and micro-copper particles having a volume average particle size of 2 µm or more and 50 µm or less, a sum of a content of the submicro-copper particles and a content of the micro-copper particles in the metal paste for bonding may be 80% by mass or more, on the basis of a total mass of the metal particles, and the content of the submicro-copper particles in the metal paste for bonding may be 30% by mass or more and 90% by mass or less, on the basis of a sum of a mass of the submicro-copper particles and a mass of the micro-copper particles.

The micro-copper particles may be in the shape of a flake.

At least one of the first member and the second member may be a semiconductor element.

Another aspect of the present invention provides a bonded body, including: a first member; a second member; and a sintered body of the metal paste for bonding according to one aspect of the present invention, which bonds the first member and the second member.

Another aspect of the present invention provides a bonded body obtained by the method for producing a bonded body according to another aspect of the present invention.

### Advantageous Effects of Invention

According to the present invention, it is possible to provide the metal paste for bonding and the method for producing a bonded body in which the bonded body having a sufficient bonding strength can be obtained even when bonded in a non-pressure condition in an atmosphere not containing hydrogen or having a low hydrogen concentration.

### Brief Description of Drawings

FIG. 1 is a schematic sectional view illustrating an example of a bonded body to be produced by using a metal paste for bonding of this embodiment.
FIG. 2 is a schematic sectional view illustrating an example of a bonded body to be produced by using a metal paste for bonding of this embodiment.
FIG. 3 is a SEM image illustrating a bonded section of a copper sintered body in a bonded body prepared by using a metal paste for bonding obtained in Example 1.
FIG. 4 is a SEM image illustrating a bonded section of a copper sintered body in a bonded body prepared by using a metal paste for bonding obtained in Comparative Example 7.

### Description of Embodiments

Hereinafter, a mode for carrying out the present invention (hereinafter, referred to as "this embodiment") will be described in detail. The present invention is not limited to the following embodiment.

### <Metal Paste for Bonding>

A metal paste for bonding of this embodiment contains metal particles, a dispersion medium, and a sintering accelerator, the metal particles contain copper particles, and the sintering accelerator is a coordinating compound having electron back donation properties.

The metal paste for bonding of this embodiment may contain one or more types among a nitrogen-containing aromatic heterocyclic compound, an acetylene derivative, an ethylene derivative, an organic arsenic compound, and a cyanide, as the coordinating compound. According to such a metal paste for bonding, even in a case where members are bonded in a non-pressure condition in an atmosphere not containing hydrogen or having a low hydrogen concentration, it is easy to perform sintering (to form a metallic bond) while maintaining a metal surface by removing an oxide film on the copper particles and an adherend, and it is possible to obtain a bonded body having a sufficient bonding strength. The present inventors have considered that the reason for obtaining such an effect is that a copper complex having a back donation bond with the coordinating compound tends to be stabilized in the state of a low oxidation number, and copper in an oxidized state is easily reduced to metal copper, which accelerates the sintering of the copper particles.

### [Copper Particles]

Examples of the copper particles include submicro-copper particles and micro-copper particles. Note that, the copper particles indicate particles containing copper as a main component, and for example, indicate particles in which the content ratio of copper in the particles is 80% by mass or more. The content ratio of the copper in the copper particles may be 85% by mass or more, 90% by mass or more, 95% by mass or more, 99% by mass or more, or 100% by mass.

### (Submicro-Copper Particles)

The submicro-copper particles may be copper particles having sintering properties in a temperature range of 250°C or higher and 380°C or lower. Examples of the submicro-copper particles include copper particles having a particle size of 0.01 µm or more and 0.8 µm or less, and for example, copper particles having a volume average particle size of 0.01 µm or more and 0.8 µm or less can be used. In a case where the volume average particle size of the submicro-copper particles is 0.01 µm or more, it is easy to obtain effects such as suppressing the synthesis cost of the submicro-copper particles, excellent dispersibility, and suppressing the amount of organic protective agent used. In a case where the volume average particle size of the submicro-copper particles is 0.8 µm or less, it is easy to obtain an effect such as excellent sintering properties of the submicro-copper particles. From the viewpoint of further obtaining the effects described above, the volume average particle size of the submicro-copper particles may be 0.6 µm or less, may be 0.5 µm or less, or may be 0.4 µm or less. In addition, the volume average particle size of the submicro-copper particles may be 0.02 µm or more, may be 0.05 µm or more, or may be 0.1 µm or more. The volume average particle size of the submicro-copper particles, for example, may be 0.01 µm or more and 0.5 µm or less, may be 0.12 µm or more and 0.8 µm or less, may be 0.15 µm or more and 0.8 µm or less, may be 0.15 µm or more and 0.6 µm or less, may be 0.2 µm or more and 0.5 µm or less, or may be 0.3 µm or more and 0.45 µm or less.

Note that, in this specification, the volume average particle size indicates 50% volume average particle size. The volume average particle size of the copper particles can be obtained by a method of dispersing the copper particles as a raw material or dry copper particles obtained by removing a volatile component from the metal paste for bonding in a dispersion medium with a dispersant, and performing measurement with a light scattering particle size distribution analyzer (for example, a Shimadzu nanoparticle size distribution analyzer (SALD-7500nano, manufactured by SHIMADZU CORPORATION)). In the case of using the light scattering particle size distribution analyzer, hexane, toluene, α-terpineol, 4-methyl-1,3-dioxolan-2-one, water, or the like can be used as the dispersion medium.

The content of the submicro-copper particles may be 20% by mass or more, may be 30% by mass or more, may be 35% by mass or more, may be 40% by mass or more, may be 90% by mass or less, may be 85% by mass or less, may be 80% by mass or less, may be 20% by mass or more and 90% by mass or less, may be 30% by mass or more and 90% by mass or less, may be 35% by mass or more and 85% by mass or less, or may be 40% by mass or more and 80% by mass or less, on the basis of the total mass of the metal particles. In a case where the content of the submicro-copper particles is in the range described above, it is easy to ensure the bonding strength of a bonded body to be produced by sintering a copper paste for bonding, and in a case where the copper paste for bonding is used for the bonding of a semiconductor element, a semiconductor device tends to exhibit excellent die shear strength and connection reliability.

It is preferable that the content of the submicro-copper particles is 20% by mass or more and 90% by mass or less, on the basis of the sum of the total mass of the copper particles. In a case where the content of the submicro-copper particles is 20% by mass or more, the submicro-copper particles may sufficiently fill a gap between the copper particles when used together with the micro-copper particles such as flake-shaped micro-copper particles, it is easy to ensure the bonding strength of the bonded body to be produced by sintering the copper paste for bonding, and in a case where the copper paste for bonding is used for the bonding of the semiconductor element, the semiconductor device tends to exhibit excellent die shear strength and connection reliability. In a case where the content of the submicro-copper particles is 90% by mass or less, since it is possible to sufficiently suppress a volume contraction when sintering the copper paste for bonding in a non-pressure condition, it is easy to ensure the bonding strength of the bonded body to be produced by sintering the copper paste for bonding, and in a case where the copper paste for bonding is used for the bonding of the semiconductor element, the semiconductor device tends to exhibit excellent die shear strength and connection reliability. From the viewpoint of further obtaining the effects described above, the content of the submicro-copper particles may be 30% by mass or more, may be 35% by mass or more, may be 40% by mass or more, may be 85% by mass or less, may be 83% by mass or less, may be 80% by mass or less, may be 30% by mass or more and 85% by mass or less, may be 35% by mass or more and 85% by mass or less, or may be 40% by mass or more and 80% by mass or less, on the basis of the total mass of the copper particles.

The shape of the submicro-copper particles is not particularly limited. Examples of the shape of the submicro-copper particles include a spherical shape, a lump shape, a needle shape, a flake shape, approximately a spherical shape, and an aggregate thereof. The shape of the submicro-copper particles may be a spherical shape, approximately a spherical shape, and a flake shape, from the viewpoint of the dispersibility and filling properties, and may be a spherical shape or approximately a spherical shape, from the viewpoint of combustibility, the dispersibility, mixability with flake-shaped micro-particles, and the like. In this specification, the "flake shape" includes a flat plate shape such as a plate shape and a scale shape.

The aspect ratio of the submicro-copper particles may be 5 or less, may be 4 or less, or may be 3 or less, from the viewpoint of the dispersibility, the filling properties, and the mixability with the flake-shaped micro-particles. In this specification, the "aspect ratio" indicates Long Side (Major Axis)/Thickness of the particles. The long side (the major axis) and the thickness of the particles can be measured, for example, from a SEM image of the particles.

The submicro-copper particles may be treated with a surface treatment agent. Examples of the surface treatment agent include an organic acid having 2 to 18 carbon atoms. Examples of the organic acid having 2 to 18 carbon atoms include a saturated fatty acid such as an acetic acid, a propionic acid, a butanoic acid, a pentanoic acid, a hexanoic acid, a heptanoic acid, a caprylic acid, a methyl heptanoic acid, an ethyl hexanoic acid, a propyl pentanoic acid, a pelargonic acid, a methyl octanoic acid, an ethyl heptanoic acid, a propyl hexanoic acid, a capric acid, a methyl nonanoic acid, an ethyl octanoic acid, a propyl heptanoic acid, a butyl hexanoic acid, an undecanoic acid, a methyl decanoic acid, an ethyl nonanoic acid, a propyl octanoic acid, a butyl heptanoic acid, a lauric acid, a methyl undecanoic acid, an ethyl decanoic acid, a propyl nonanoic acid, a butyl octanoic acid, a pentyl heptanoic acid, a tridecanoic acid, a methyl dodecanoic acid, an ethyl undecanoic acid, a propyl decanoic acid, a butyl nonanoic acid, a pentyl octanoic acid, a myristic acid, a methyl tridecanoic acid, an ethyl dodecanoic acid, a propyl undecanoic acid, a butyl decanoic acid, a pentyl nonanoic acid, a hexyl octanoic acid, a pentadecanoic acid, a methyl tetradecanoic acid, an ethyl tridecanoic acid, a propyl dodecanoic acid, a butyl undecanoic acid, a pentyl decanoic acid, a hexyl nonanoic acid, a palmitic acid, a methyl pentadecanoic acid, an ethyl tetradecanoic acid, a propyl tridecanoic acid, a butyl dodecanoic acid, a pentyl undecanoic acid, a hexyl decanoic acid, a heptyl nonanoic acid, a heptadecanoic acid, an octadecanoic acid, a methyl cyclohexane carboxylic acid, an ethyl cyclohexane carboxylic acid, a propyl cyclohexane carboxylic acid, a butyl cyclohexane carboxylic acid, a pentyl cyclohexane carboxylic acid, a hexyl cyclohexane carboxylic acid, a heptyl cyclohexane carboxylic acid, an octyl cyclohexane carboxylic acid, and a nonyl cyclohexane carboxylic acid; an unsaturated fatty acid such as an octenoic acid, a nonenoic acid, a methyl nonenoic acid, a decenoic acid, undecenoic acid, a dodecenoic acid, a tridecenoic acid, a tetradecenoic acid, a myristoleic acid, a pentadecenoic acid, a hexadecenoic acid, a palmitoleic acid, a sapienic acid, an oleic acid, a vaccenic acid, a linoleic acid, a linolenoic acid, and a linolenic acid; and an aromatic carboxylic acid such as a terephthalic acid, a pyromellitic acid, an o-phenoxy benzoic acid, a methyl benzoic acid, an ethyl benzoic acid, a propyl benzoic acid, a butyl benzoic acid, a pentyl benzoic acid, a hexyl benzoic acid, a heptyl benzoic acid, an octyl benzoic acid, and a nonyl benzoic acid. Only one type of organic acid may be used alone, or two or more types thereof may be used in combination. By combining such an organic acid with the submicro-copper particles, there is a tendency that the dispersibility of the submicro-copper particles and the desorption properties of the organic acid when sintered can be compatible.

The treatment amount of the surface treatment agent may be the amount of one molecular layer to three molecular layers attached to the surface of the submicro-copper particles. The amount can be calculated from the number (n) of molecular layers attached to the surface of the submicro-copper particles, a specific surface area (Aₚ) (Unit m²/g) of the submicro-copper particles, a molecular weight (Mₛ) (Unit g/mol) of the surface treatment agent, a minimum covering area (S_{S}) (Unit m²/piece) of the surface treatment agent, and an Avogadro number (N_{A}) (6.02 × 10²³ pieces). Specifically, the treatment amount of the surface treatment agent is calculated in accordance with an expression of Treatment Amount (% by mass) of Surface Treatment Agent = {(n·Aₚ·Mₛ)/(S_{S}·N_{A} + n·Aₚ·Mₛ)} × 100%.

The specific surface area of the submicro-copper particles can be calculated by measuring the dried submicro-copper particles with a BET specific surface area measurement method. In a case where the surface treatment agent is a linear saturated fatty acid, the minimum covering area of the surface treatment agent is 2.05 × 10⁻¹⁹ m²/1 molecule. In the case of the other surface treatment agent, for example, the minimum covering area can be measured by calculation from a molecular model or a method described in "Chemistry & Education" (Katsuhiro UEDA, Sumio INAFUKU, and Iwao MORI, 40(2), 1992, p114-117). An example of a method for quantifying the surface treatment agent will be given below. The surface treatment agent can be identified by a thermal desorption gas/gas chromatograph mass spectrometer of a dry powder obtained by removing the dispersion medium from the copper paste for bonding to determine the number of carbon atoms and the molecular weight of the surface treatment agent. The carbon content ratio of the surface treatment agent can be analyzed by carbon content analysis. Examples of a carbon content analysis method include a high-frequency induction heating furnace combustion/infrared absorption method. The amount of surface treatment agent can be calculated from the number of carbon atoms, the molecular weight, and the carbon content ratio of the identified surface treatment agent, in accordance with the expression described above.

The treatment amount of the surface treatment agent may be 0.07% by mass or more and 2.1% by mass or less, may be 0.10% by mass or more and 1.6% by mass or less, or may be 0.2% by mass or more and 1.1% by mass or less, on the basis of the mass of the submicro-copper particles containing the surface treatment agent.

As the submicro-copper particles, commercially available particles can be used. Examples of the commercially available submicro-particles include CH-0200 (manufactured by MITSUI MINING & SMELTING CO., LTD., a volume average particle size of 0.36 µm), CH-0200A-L1 (manufactured by MITSUI MINING & SMELTING CO., LTD., a volume average particle size of 0.21 µm), HT-14 (manufactured by MITSUI MINING & SMELTING CO., LTD., a volume average particle size of 0.41 µm), CT-500 (manufactured by MITSUI MINING & SMELTING CO., LTD., a volume average particle size of 0.72 µm), and Tn-Cu100 (manufactured by TAIYO NIPPON SANSO CORPORATION, a volume average particle size of 0.12 µm).

Since the submicro-copper particles have excellent sintering properties, it is possible to reduce problems that occur in a bonding material mainly using copper nanoparticles, such as a high synthesis cost, poor dispersibility, and the volume contraction after sintering.

### (Micro-Copper Particles)

As the micro-copper particles, copper particles having a particle size of 2 µm or more and 50 µm or less can be used, and for example, copper particles having a volume average particle size of 2 µm or more and 50 µm or less can be used. In a case where the volume average particle size of the micro-copper particles is in the range described above, it is possible to sufficiently reduce the volume contraction when sintering the copper paste for bonding in a non-pressure condition, the occurrence of voids, and the like, it is easy to ensure the bonding strength of the bonded body to be produced by sintering the copper paste for bonding in a non-pressure condition, and in a case where the copper paste for bonding is used for the bonding of the semiconductor element, the semiconductor device tends to exhibit excellent die shear strength and connection reliability. From the viewpoint of further obtaining the effects described above, the volume average particle size of the micro-copper particles may be 2 µm or more and 20 µm or less, may be 2 µm or more and 10 µm or less, may be 3 µm or more and 20 µm or less, or may be 3 µm or more and 10 µm or less.

It is preferable that the micro-copper particles are in the shape of a flake. In the case of using the flake-shaped micro-copper particles, since the micro-copper particles in the copper paste for bonding are oriented in approximately parallel to the bonding surface, it is possible to suppress the volume contraction when sintering the copper paste for bonding, and it is easy to ensure the bonding strength of the bonded body to be produced by sintering the copper paste for bonding. In a case where the copper paste for bonding is used for the bonding of the semiconductor element, the semiconductor device tends to exhibit excellent die shear strength and connection reliability. From the viewpoint of further obtaining the effects described above, the aspect ratio of the flake-shaped micro-copper particles may be 4 or more, may be 6 or more, may be 10 or more, or may be 50 or more.

The content of the micro-copper particles may be 10% by mass or more, may be 15% by mass or more, may be 20% by mass or more, may be 90% by mass or less, may be 65% by mass or less, may be 60% by mass or less, may be 10% by mass or more and 90% by mass or less, may be 15% by mass or more and 65% by mass or less, or may be 20% by mass or more and 60% by mass or less, on the basis of the total mass of the copper particles. In a case where the content of the micro-copper particles is in the range described above, it is easy to ensure the bonding strength of the bonded body to be produced by sintering the copper paste for bonding, and in a case where the copper paste for bonding is used for the bonding of the semiconductor element, the semiconductor device tends to exhibit excellent die shear strength and connection reliability.

In the micro-copper particles, whether to perform the treatment with the surface treatment agent is not particularly limited, but from the viewpoint of dispersion stability and oxidation resistance, the micro-copper particles may be treated with the surface treatment agent. The surface treatment agent may be removed when performing bonding. Examples of such a surface treatment agent include an aliphatic carboxylic acid such as a dodecanoic acid, a palmitic acid, a heptadecanoic acid, a stearic acid, an arachidic acid, a linoleic acid, a linolenoic acid, and an oleic acid; an aromatic carboxylic acid such as a terephthalic acid, a pyromellitic acid, and an o-phenoxy benzoic acid; aliphatic alcohol such as cetyl alcohol, stearyl alcohol, isobornyl cyclohexanol, and tetraethylene glycol; aromatic alcohol such as p-phenyl phenol; alkyl amine such as octyl amine, dodecyl amine, and stearyl amine; aliphatic nitrile such as stearonitrile and decane nitrile; a silane coupling agent such as alkyl alkoxy silane; a polymer treatment agent such as polyethylene glycol, polyvinyl alcohol, polyvinyl pyrrolidone, and a silicone oligomer, and the like. Only one type of surface treatment agent may be used alone, or two or more types thereof may be used in combination.

The treatment amount of the surface treatment agent is the amount of one or more molecular layers on the surface of the particles. Such a treatment amount of the surface treatment agent is changed in accordance with the specific surface area of the micro-copper particles, the molecular weight of the surface treatment agent, and the minimum covering area of the surface treatment agent. The treatment amount of the surface treatment agent may be 0.001% by mass or more, may be 0.4% by mass or more, may be 0.5% by mass or more, may be 2.0% by mass or less, may be 1.7% by mass or less, may be 0.001% by mass or more and 2.0% by mass or less, may be 0.4% by mass or more and 2.0% by mass or less, or may be 0.5% by mass or more and 1.7% by mass or less, on the basis of the mass of the micro-copper particles containing the surface treatment agent. The specific surface area of the micro-copper particles, the molecular weight of the surface treatment agent, and the minimum covering area of the surface treatment agent can be calculated by the same method as that in the case of the submicro-copper particles described above.

As the micro-copper particles, commercially available particles can be used. Examples of the commercially available flake-shaped micro-particles include MA-C025KFD (manufactured by MITSUI MINING & SMELTING CO., LTD., a volume average particle size of 7.5 µm), 3L3N (manufactured by FUKUDA METAL FOIL & POWDER CO., LTD., a volume average particle size of 6 µm), 2L3N (manufactured by FUKUDA METAL FOIL & POWDER CO., LTD., a volume average particle size of 9.9 µm), 4L3N (manufactured by FUKUDA METAL FOIL & POWDER CO., LTD., a volume average particle size of 3 µm), C3 (manufactured by FUKUDA METAL FOIL & POWDER CO., LTD., a volume average particle size of 37 µm), and 1110F (manufactured by MITSUI MINING & SMELTING CO., LTD., a volume average particle size of 3.8 µm).

The copper paste for bonding according to this embodiment may contain the submicro-copper particles and the micro-copper particles. In the case of preparing the copper paste for bonding only from the submicro-copper particles described above, since the volume contraction and a sintering contraction due to the drying of the dispersion medium are considerable, the copper paste for bonding is likely to be peeled off from the adherend surface when sintered, and it is difficult to obtain sufficient die shear strength and connection reliability in the bonding of the semiconductor element or the like. In the case of preparing the copper paste for bonding only from the micro-copper particles described above, there is a tendency that a sintering temperature increases, and a sintering step of 400°C or higher is required. By using the submicro-copper particles and the micro-copper particles together, the volume contraction when sintering non-pressure copper paste for bonding is suppressed, and the bonded body may have a sufficient bonding strength. In a case where the non-pressure copper paste for bonding is used for the bonding of the semiconductor element, an effect is obtained in which the semiconductor device exhibits excellent die shear strength and connection reliability.

From the above viewpoint, the copper paste for bonding according to this embodiment contains submicro-copper particles having a volume average particle size of 0.15 µm or more and 0.8 µm or less, and micro-copper particles having a volume average particle size of 2 µm or more and 50 µm or less, as the copper particles, the sum of the content of the submicro-copper particles and the content of the micro-copper particles is 80% by mass or more, on the basis of the total mass of the metal particles, and the content of the submicro-copper particles may be 30% by mass or more, may be 90% by mass or less, or may be 30% by mass or more and 90% by mass or less, on the basis of the sum of the mass of the submicro-copper particles and the mass of the micro-copper particles.

### (Metal Particles Other than Copper Particles)

The metal paste for bonding of this embodiment may contain metal particles (the other metal particles) containing a metal element other than copper, as the metal particles. Examples of the other metal particles include particles of zinc, gold, palladium, silver, nickel, platinum, brass, manganese, tin, antimony, indium, aluminum, vanadium, and the like. The volume average particle size of the other metal particles may be 0.01 µm or more, may be 0.03 µm or more, may be 0.05 µm or more, may be 10 µm or less, may be 5 µm or less, may be 3 µm or less, may be 0.01 µm or more and 10 µm or less, may be 0.01 µm or more and 5 µm or less, or may be 0.05 µm or more and 3 µm or less.

In a case where the copper paste for bonding contains the other metal particles, since a sintered body can be obtained in which a plurality of types of metals are dissolved or dispersed, the mechanical characteristics of the sintered body, such as a yield stress and a fatigue strength, are improved, and the connection reliability is easily improved. In addition, by adding a plurality of types of metal particles, the sintered body of the copper paste for bonding may have a sufficient bonding strength with respect to a specific adherend. In a case where the copper paste for bonding is used for the bonding of the semiconductor element, the die shear strength and the connection reliability of the semiconductor device are easily improved.

In a case where the copper paste for bonding contains the other metal particles, the content thereof may be less than 5% by mass, may be 3% by mass or less, or may be 1% by mass or less, on the basis of the total mass of the metal particles, from the viewpoint of obtaining sufficient bonding properties. The copper paste for bonding may not contain the other metal particles. The shape of the metal particles is not particularly limited.

In the metal paste for bonding of this embodiment, the content of inorganic particles other than the metal particles may be 30% by mass or less, may be 20% by mass or less, or may be 1% by mass or less, on the basis of the total amount of the metal paste for bonding. The copper paste for bonding may not contain the inorganic particles other than the metal particles.

### [Sintering Accelerator]

As the sintering accelerator, a coordinating compound capable of forming a copper complex can be used, and examples thereof include a coordinating compound having electron back donation properties. The coordinating compound may be a compound having both of a lone electron pair and an empty π-electron orbit. According to such a compound, a bond with a copper metal atom is formed by the lone electron pair, and a back donation bond between an empty π-orbit and a d-orbital electron of copper can be formed.

Examples of the coordinating compound include a nitrogen-containing aromatic heterocyclic compound, an acetylene derivative, an ethylene derivative, an organic arsenic compound, and a cyanide.

Examples of the nitrogen-containing aromatic heterocyclic compound include a pyridine compound, a diazine compound, a triazine compound, a pyrrole compound, an azole compound, a triazole compound, and a phenanthroline compound. The nitrogen-containing aromatic heterocyclic compound may be a compound having an electrophilic substituent. Examples of the electrophilic substituent include a cyano group, an ester group, a nitro group, a halogen group, and a trifluoromethyl group.

Examples of the pyridine compound include 2,2'-bipyridyl, quinoline, isoquinoline, 6,6'-dibromo-2,2'-bipyridyl, dimethyl 2,2'-bipyridine-4,4'-dicarboxylate, 2,2':6',2"-terpyridine, 4-amino-2-chloro-3-nitropyridine, 2-cyanopyrimidine, 4-nitropyridine, 2,6-dichloro-4-nitropyridine, 2,6-dichloropyridine, and 2,2'-biquinoline.

Examples of the diazine compound include pyridazine, 3,6-dichloropyridazine, pyridazine-3-carbonitrile, 4-(trifluoromethyl) pyridazine, pyrazine, pyrimidine, 2-pyrimidine carbonitrile, quinazoline, quinoxaline, cinnoline, phthalazine, 1,4-dichlorophthalazine, 4-pyridazine carbonyl, 4-(trifluoromethyl) pyridazine, cyanopyrazine, and 2,3-pyrazine dicarbonitrile.

Examples of the triazine compound include 1,2,3-triazine, 1,2,4-triazine, 1,3,5-triazine, and 1,3,5-triazine-2,4,6-trithiol.

Examples of the pyrrole compound include pyrrole and carbazole.

Examples of the azole compound include imidazole, 1-ethyl imidazole, and benzoimidazole.

Examples of the triazole compound include 1,2,3-triazole, 1,2,4-triazole, and benzotriazole.

Examples of the phenanthroline compound include 1,10-phenanthroline, 4,5-diazafluoren-9-one, and 1,10-phenanthroline-5,6-dione.

The acetylene derivative and the ethylene derivative may be a compound having an electrophilic substituent such as a cyano group, an ester group, a nitro group, and a trifluoromethyl group, and examples thereof include a fumaric acid, dimethyl fumarate, diethyl fumarate, diisobutyl fumarate, a maleic acid, tetracyanoethylene, nitrostyrene, tetracyanoethylene, fumaronitrile, benzylidene malononitrile, crotononitrile, acrylonitrile, 3-phenyl-2-propyne nitrile, ethyl trifluoro-2-butynoate, and methyl 2-(trifluoromethyl) acrylate.

Examples of the organic arsenic compound include trimethyl arsine, dimethyl arsine, triphenyl arsine, and tetramethyl diarsane.

Examples of the cyanide include hydrogen cyanide, potassium cyanide, sodium cyanide, mandelonitrile, and polyacrylonitrile.

Among the coordinating compounds described above, a compound that is a solid or a liquid at 30°C may be used, a compound that is a solid or a liquid at 25°C may be used, or a compound that is a solid or a liquid at 20°C may be used, from the viewpoint of being easily compounded with the copper paste for bonding. In a case where the coordinating compound is a gas at a room temperature, sintering may be performed in an atmosphere containing the coordinating compound, or the coordinating compound may be supplied by spraying when performing sintering.

Among the coordinating compounds described above, at least one type selected from the group consisting of 2,2'-bipyridyl, 1,10-phenanthroline, 1-ethyl imidazole, 3,6-dichloropyridazine, and 2-cyanopyrimidine may be used, from the viewpoint of obtaining a higher sintering accelerative effect.

Only one type of sintering accelerator can be used alone, or two or more types thereof can be used in combination.

The sintering accelerator has a 95% weight loss temperature when measured with thermogravimetry-differential thermal analysis (TG-DTA) in a nitrogen atmosphere may be 240°C or higher, may be 220°C or higher, may be 200°C or higher, or may be 150°C or higher. A sufficient amount of sintering accelerator is easily ensured in a system from approximately 130°C to approximately 200°C in which the copper particles are reduced. The 95% weight loss temperature of the sintering accelerator may be 400°C or lower, may be 350°C or lower, or may be 320°C or lower. Such a sintering accelerator is easily removed by thermal decomposition during sintering. Accordingly, the sintered body, for example, may have characteristics such as being less likely to cause corrosion, and it is easy to maintain a sufficient bonding strength for a long period of time.

Note that, in this specification, the 95% weight loss temperature is measured by placing approximately 20 mg of a measurement sample on an Al sample pan for TG-DTA measurement to set the sample on a specimen holder of a TG-DTA measurement device (manufactured by SII NanoTechnology Inc., EXSTAR6000 TG/DTA6300). The sample is heated from 50°C to approximately 500°C at a temperature increase rate of 10°C/minute while flowing nitrogen at a flow rate of approximately 400 mL/minute, and the 95% weight loss temperature is obtained on the basis of a weight change in this case.

The 95% weight loss temperature of the coordinating compound, for example, is 154°C for 2,2'-bipyridyl.

With respect to 100 parts by mass of the total mass of the copper particles, the content of the sintering accelerator in the copper paste for bonding may be 0.01 parts by mass or more, may be 0.05 parts by mass or more, may be 0.1 parts by mass or more, may be 0.5 parts by mass or more, may be 0.6 parts by mass or more, may be 0.7 parts by mass or more, or may be 0.8 parts by mass or more, from the viewpoint of suppressing a sintering defect and ensuring the bonding strength, and may be 10 parts by mass or less, may be 9.0 parts by mass or less, or may be 7.7 parts by mass or less, from the viewpoint of suppressing a decrease in the bonding strength due to the excess sintering accelerator. From the viewpoint of suppressing a decrease in the bonding strength due to the excess sintering accelerator while suppressing the sintering defect and ensuring the bonding strength, the content of the sintering accelerator in the copper paste for bonding may be 0.01 parts by mass or more and 10 parts by mass or less, may be 0.05 parts by mass or more and 10 parts by mass or less, may be 0.1 parts by mass or more and 10 parts by mass or less, may be 0.5 parts by mass or more and 10 parts by mass or less, may be 0.6 parts by mass or more and 10 parts by mass or less, may be 0.7 parts by mass or more and 9.0 parts by mass or less, or may be 0.8 parts by mass or more and 7.7 parts by mass or less, with respect to 100 parts by mass of the total mass of the copper particles.

Among the coordinating compounds described above, 2,2'-bipyridyl, 1,10-phenanthroline, 1-ethyl imidazole, 3,6-dichloropyridazine, and 2-cyanopyrimidine can be used, for example, in the following compound amount, with respect to 100 parts by mass of the total mass of the copper particles.
2,2'-Bipyridyl: 0.5 parts by mass to 3.0 parts by mass
1,10-Phenanthroline: 0.05 parts by mass to 0.8 parts by mass
1-Ethyl Imidazole: 0.01 parts by mass to 0.4 parts by mass
3,6-Dichloropyridazine: 0.01 parts by mass to 1.7 parts by mass
2-Cyanopyrimidine: 0.01 parts by mass to 0.3 parts by mass

In addition, in a case where the copper paste for bonding contains the copper particles and the other metal particles, the content of the sintering accelerator may be in the range described above with respect to 100 parts by mass of the total mass of the metal particles. Examples of the other metal particles include particles of zinc, gold, palladium, silver, nickel, platinum, brass, manganese, tin, antimony, indium, aluminum, vanadium, and the like.

### [Reductant]

The copper paste for bonding may further contain a reductant. In this case, in sintering in nitrogen, it is easy to perform the sintering (to form a metallic bond) while maintaining the metal surface by removing the oxide film on the copper particles and the adherend.

As the reductant, a polyol-based compound can be used. The polyol-based compound may be a compound having a plurality of OH groups. Examples of the polyol-based compound include diethylene glycol, triethylene glycol, tetraethylene glycol, pentaethylene glycol, hexaethylene glycol, dipropylene glycol, tripropylene glycol, tetrapropylene glycol, polyethylene glycol, polyethylene glycol 200, polyethylene glycol 300, polyethylene glycol 400, polypropylene glycol, polypropylene glycol 200, polypropylene glycol 300, polypropylene glycol 400, polypropylene glycol 700, polypropylene glycol 4000, polyethylene glycol monooleate, polyethylene glycol monostearate, polyethylene glycol monolaurate, polyoxyethylene sorbitan monolaurate, polyoxyethylene polyoxypropylene glycol, and the like.

Only one type of reductant can be used alone, or two or more types thereof can be used in combination.

The reductant has a 95% weight loss temperature when measured with TG-DTA in a nitrogen atmosphere may be 300°C or higher. A sufficient amount of reductant is easily ensured in a system while the copper particles are reduced and then sintered. The 95% weight loss temperature of the reductant may be 420°C or lower, may be 400°C or lower, or may be 380°C or lower. Since such a reductant is less likely to remain after sintering, the sintered body, for example, may have characteristics such as having a sufficient sintering degree and being less likely to cause corrosion, and it is easy to maintain a sufficient bonding strength for a long period of time.

The copper paste for bonding may contain a polyol-based compound satisfying the condition of the 95% weight loss temperature described above, from the viewpoint of the long-term stability of the bonding strength.

Examples of the 95% weight loss temperature of the polyol-based compound described above include Polyethylene Glycol 200: 322°C, Polyethylene Glycol 300: 380°C, Polyethylene Glycol 400: 410°C, Polypropylene Glycol 300 (triol type): 337°C, Polypropylene Glycol 400 (diol type): 343°C, Polypropylene Glycol 700 (diol type): 383°C, and Polypropylene Glycol 4000 (triol type): 390°C.

With respect to 100 parts by mass of the total mass of the copper particles, the content of the reductant in the copper paste for bonding may be 1.6 parts by mass or more, may be 1.8 parts by mass or more, may be 2.0 parts by mass or more, or may be 4.0 parts by mass or more, from the viewpoint of suppressing the sintering defect and ensuring the bonding strength, and may be 10 parts by mass or less, may be 9.0 parts by mass or less, or may be 8.5 parts by mass or less, from the viewpoint of suppressing a decrease in the bonding strength due to the excess reductant.

In addition, in a case where the copper paste for bonding contains the copper particles and the other metal particles, the content of the reductant may be in the range described above with respect to 100 parts by mass of the total mass of the metal particles. Examples of the other metal particles include particles of zinc, gold, palladium, silver, nickel, platinum, brass, manganese, tin, antimony, indium, aluminum, vanadium, and the like.

### [Dispersion Medium]

Examples of the dispersion medium include monohydric and polyhydric alcohols such as pentanol, hexanol, heptanol, octanol, decanol, dihydroterpineol, terpineol, and isobornyl cyclohexanol (MTPH); ethers such as ethylene glycol butyl ether, ethylene glycol phenyl ether, diethylene glycol methyl ether, diethylene glycol ethyl ether, diethylene glycol butyl ether, diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, and tripropylene glycol dimethyl ether; esters such as ethylene glycol ethyl ether acetate, ethylene glycol butyl ether acetate, diethylene glycol ethyl ether acetate, diethylene glycol butyl ether acetate, dipropylene glycol methyl ether acetate (DPMA), ethyl lactate, butyl lactate, γ-butyrolactone, and propylene carbonate; acid amide such as N-methyl-2-pyrrolidone, N,N-dimethyl acetamide, and N,N-dimethyl formamide; aliphatic hydrocarbon such as cyclohexanone, octane, nonane, decane, and undecane; aromatic hydrocarbon such as benzene, toluene, and xylene; mercaptans having an alkyl group having 1 to 18 carbon atoms; and mercaptans having a cycloalkyl group having 5 to 7 carbon atoms. Examples of the mercaptans having an alkyl group having 1 to 18 carbon atoms include ethyl mercaptan, n-propyl mercaptan, i-propyl mercaptan, n-butyl mercaptan, i-butyl mercaptan, t-butyl mercaptan, pentyl mercaptan, hexyl mercaptan, and dodecyl mercaptan. Examples of the mercaptans having a cycloalkyl group having 5 to 7 carbon atoms include cyclopentyl mercaptan, cyclohexyl mercaptan, and cycloheptyl mercaptan.

The dispersion medium may contain a solvent having a boiling point of 140°C or higher, may contain a solvent having a boiling point of 170°C or higher, or may contain a solvent having a boiling point of 200°C or higher, from the viewpoint of printing life (on-plate life). In addition, since the solvent is required to be removed after sintering, the boiling point of the solvent may be 400°C or lower, may be 380°C or lower, or may be 360°C or lower.

Only one type of dispersion medium can be used alone, or two or more types thereof can be used in combination.

### [Additive]

The metal paste for bonding may further contain additives such as a dispersant, a surface protective agent, a thickener, and a thixotropy imparting agent, as necessary.

In a case where the metal paste for bonding contains the additive, the content of the additive having non-volatility or non-decomposability at a temperature of 200°C or lower may be 20% by mass or less, may be 5% by mass or less, or may be 1% by mass or less, on the basis of the total amount of the metal paste for bonding, from the viewpoint of suppressing a decrease in the sintering properties of the metal paste for bonding.

### <Method for Preparing Metal Paste for Bonding>

The metal paste for bonding of this embodiment can be prepared by mixing the copper particles (for example, the submicro-copper particles and the micro-copper particles), the sintering accelerator, the dispersion medium, and as necessary, the reductant, the other metal particles, and any additive. After mixing each component, a stirring treatment may be performed. The maximum particle size of the dispersion liquid in the metal paste for bonding may be adjusted by a classification operation.

The metal paste for bonding may be prepared by mixing in advance the submicro-copper particles, the organic protective agent, the sintering accelerator, and the dispersion medium, performing a dispersion treatment to prepare a dispersion liquid of the submicro-copper particles, and further mixing the remaining components. According to such a procedure, the dispersibility of the submicro-copper particles is improved to make the mixability with the micro-copper particles (for example, the flake-shaped micro-copper particles) excellent, and the performance of the copper paste for bonding can be further improved. In addition, an aggregate may be removed from the dispersion liquid of the submicro-copper particles by the classification operation. The submicro-copper particles and the organic protective agent may be submicro-copper particles treated with the organic protective agent.

The stirring treatment can be performed by using a stirrer. Examples of the stirrer include an Ishikawa-type stirrer, a Silverson stirrer, a cavitation stirrer, a planetary centrifugal stirrer, an ultra-thin-film highspeed rotating disperser, an ultrasonic disperser, a mortar machine, a twin-screw kneader, a bead mill, a ball mill, a three-roll mill, a homomixer, a planetary mixer, an ultrahigh-pressure disperser, a thin-layer shear disperser, and a disperizer.

Examples of the dispersion treatment include a thin-layer shear disperser, a disperizer, a bead mill, an ultrasonic homogenizer, a high-shear mixer, a narrow-gap three-roll mill, a wet-type super atomizer, a supersonic jet mill, and an ultrahigh-pressure homogenizer.

The classification operation, for example, can be performed by using filtration, natural sedimentation, and centrifugation. Examples of a filter for filtration include a water comb, a metal mesh, a metal filter, and a nylon mesh.

The copper paste for bonding may have a viscosity adjusted to be suitable for a printing/applying method. As the viscosity of the copper paste for bonding, for example, a Casson viscosity at 25°C may be 0.05 Pa·s or more, may be 0.06 Pa·s or more, may be 2.0 Pa·s or less, may be 1.0 Pa·s or less, may be 0.05 Pa·s or more and 2.0 Pa·s or less, or may be 0.06 Pa·s or more and 1.0 Pa·s or less. The Casson viscosity at 25°C can be measured by using a viscoelasticity measurement device.

### <Method for Producing Bonded Body>

### [First Embodiment]

A method for producing a bonded body according to a first embodiment includes a first laminated body preparing step of preparing a laminated body in which a first member, the metal paste for bonding according to this embodiment described above, and a second member are laminated in this order, and a first sintering step of sintering the metal paste for bonding in the laminated body.

### (First Laminated Body Preparing Step)

Examples of the first member and the second member include a semiconductor element such as IGBT, a diode, a Schottky barrier diode, MOS-FET, a thyristor, a logic, a sensor, an analog integrated circuit, LED, a semiconductor laser, and a transmitter, a base material for mounting a semiconductor element such as a lead frame, a ceramic substrate with a metal plate (for example, DBC), and a LED package, a power supply member such as a copper ribbon, a metal block, and a terminal, a heat sink, a cooling plate, and the like.

The first member and the second member may include a metal layer for forming a metallic bond with the sintered body of the metal paste for bonding, on the bonding surface. Examples of the metal configuring the metal layer include copper, nickel, silver, gold, palladium, platinum, lead, tin, cobalt, and the like. Only one type of metal may be used alone, or two or more types thereof may be used in combination. In addition, the metal layer may be an alloy of the metals described above. Examples of the metal used for the alloy include zinc, manganese, aluminum, beryllium, titanium, chromium, iron, molybdenum, and the like, in addition to the metals described above. Examples of the member including the metal layer include a member plated with various metals, a wire, a chip plated with a metal, a heat spreader, a ceramic substrate with a metal plate, a lead frame plated with various metals or a lead frame consisting of various metals, a copper plate, and a copper foil.

The laminated body, for example, can be prepared by providing the metal paste for bonding of this embodiment in a necessary portion of the second member, and then, disposing the first member on the metal paste for bonding. In this case, it is possible to prepare a laminated body in which the first member, the metal paste for bonding on the side of a direction to which the weight of the first member is applied, and the second member are laminated in this order, and it is possible to sinter the metal paste for bonding of the laminated body in a non-pressure condition, that is, in the state of receiving only the weight of the first member, or only the weight of the first member and the weight of a weight used to prevent chip inclination or reduce voids. The weight of the weight may be 0.01 MPa or less in terms of pressure. Note that, the direction to which the weight of the first member is applied can also be a direction to which the gravity is applied.

Examples of the weight include a metal weight that has a size equivalent to the size of the chip and has a thickness of 20 mm or less. As the metal weight, a SUS weight having a thickness of 5 mm or less or the like can be used.

A method for providing the metal paste for bonding of this embodiment in the necessary portion of the second member may be a method for depositing the copper paste for bonding. As the method, ink jet printing, super ink j et printing, screen printing, transfer printing, offset printing, a jet printing method, a dispenser, a jet dispenser, a needle dispenser, a comma coater, a slit coater, a die coater, a gravure coater, slit coating, anastatic printing, intaglio printing, gravure printing, stencil printing, soft lithography, bar coating, an applicator, a particle deposition method, a spray coater, a spin coater, a dip coater, electrophoretic coating, and the like can be used.

The thickness of the metal paste for bonding may be 1 µm or more, may be 5 µm or more, may be 10 µm or more, or may be 20 µm or more. In addition, the thickness of the metal paste for bonding may be 3000 µm or less, may be 1000 µm or less, may be 500 µm or less, may be 300 µm or less, may be 250 µm or less, may be 200 µm or less, or may be 150 µm or less.

The applied metal paste for bonding may be suitably dried from the viewpoint of suppressing the occurrence of fluidity and voids when sintered. The gas atmosphere when performing drying may be the air, may be an oxygen-free atmosphere such as nitrogen or rare gas, or may be a reductive atmosphere such as hydrogen or a formic acid. A drying method may be drying by leaving to stand still at a room temperature, may be heating drying, or may be drying under a reduced pressure.

In the heating drying or the drying under a reduced pressure, for example, a hot plate, a hot-air drier, a hot-air heating furnace, a nitrogen drier, an infrared drier, an infrared heating furnace, a far-infrared heating furnace, a microwave heating device, a laser heating device, an electromagnetic heating device, a heater heating device, a vapor heating furnace, a hot-plate press device, and the like can be used. Drying temperature and time may be suitably adjusted in accordance with the type and the amount of used dispersion medium. As the drying temperature and time, it is desirable to perform drying at 50°C or higher and 150°C or lower in the air or in an oxygen-free atmosphere.

Examples of a method for disposing the first member on the metal paste for bonding include a chip mounter, a flip chip bonder, and a carbon or ceramic positioning jig.

### (First Sintering Step)

In the first sintering step, the copper paste for bonding can be sintered by performing a heating treatment in a non-pressure condition in an oxygen-free atmosphere. The oxygen-free atmosphere may be an atmosphere not containing hydrogen or having a hydrogen concentration of 10% or less. Note that, the oxygen-free atmosphere indicates an atmosphere having an oxygen concentration of 1% by volume or less, and the oxygen concentration may be 0.1% by volume or less, may be 0.01% by volume or less, or may be 0.001% by volume or less.

In the heating treatment, a heating device not including a crimping mechanism can be used. Examples of the heating device include a hot plate, a hot-air drier, a hot-air heating furnace, a nitrogen drier, an infrared drier, an infrared heating furnace, a far-infrared heating furnace, a microwave heating device, a laser heating device, an electromagnetic heating device, a heater heating device, a vapor heating furnace, and the like.

Examples of the atmosphere not containing hydrogen include non-oxidizing gas such as nitrogen, rare gas, heat-resistant organic gas, aqueous vapor, and mixed gas thereof, or a vacuum.

The gas atmosphere when performing sintering may be a reductive atmosphere. Examples of the reductive atmosphere include nitrogen containing formic acid gas, rare gas containing formic acid gas, non-oxidizing gas containing 10% or less of hydrogen, and the like. In addition, the gas atmosphere when performing sintering may be forming gas (nitrogen containing hydrogen of a lower explosion limit or less (for example, 5% or less or 3% or less)), or may be low-molecular-weight alcohol (for example, methanol or ethanol) vapor.

The highest attainable temperature when performing the heating treatment may be 200°C or higher, may be 220°C or higher, or may be 250°C or higher, from the viewpoint of improving a yield, may be 450°C or lower, may be 400°C or lower, may be 350°C or lower, or may be 300°C or lower, from the viewpoint of reducing a heat damage to the member to be bonded, and may be 200°C or higher and 450°C or lower, may be 250°C or higher and 400°C or lower, may be 250°C or higher and 350°C or lower, or may be 250°C or higher and 300°C or lower, from the viewpoint of reducing the heat damage to the member to be bonded and improving the yield.

The retention time of the highest attainable temperature may be 1 minute or longer and 60 minutes or shorter, may be 1 minute or longer and shorter than 40 minutes, or may be 1 minute or longer and shorter than 30 minutes, from the viewpoint of volatilizing the entire dispersion medium and improving the yield. In particular, in a case where the highest attainable temperature is 250°C or higher, it is easy to sufficiently perform sintering for a retention time of 60 minutes or shorter.

### [Second Embodiment]

A method for producing a bonded body according to a second embodiment includes a second laminated body preparing step of preparing a second laminated body in which a first member, a second metal paste for bonding containing metal particles and a dispersion medium, and a second member are laminated in this order, and a second sintering step of sintering the metal paste for bonding in the laminated body in the presence of a sintering accelerator.

In the method for producing a bonded body described above, the metal particles contain copper particles, and the sintering accelerator is a coordinating compound having electron back donation properties.

### (Second Laminated Body Preparing Step)

The second metal paste for bonding may have the same composition as that of the metal paste for bonding according to this embodiment described above, but may not contain the sintering accelerator.

The second laminated body can be prepared as with the first embodiment described above, except that the second metal paste for bonding is used.

### (Second Sintering Step)

In the second sintering step, the copper paste for bonding can be sintered by performing a heating treatment in a non-pressure condition in an oxygen-free atmosphere. The oxygen-free atmosphere can be the same as that in the first sintering step described above.

The heating treatment can be the same as that in the first sintering step described above.

In the second embodiment, as the coordinating compound used as the sintering accelerator, at least one type selected from the group consisting of carbon monoxide, ethylene, nitrogen monoxide, and hydrogen cyanide can be used. Such coordinating compounds can be supplied in an oxygen-free atmosphere.

In addition, it is possible to heat and gasify a liquid sintering accelerator with a high vapor pressure, allow non-oxidizing gas to bubble in the liquid sintering accelerator with a high vapor pressure, or spray the liquid sintering accelerator with a high vapor pressure into non-oxidizing gas to be used as mixed gas.

The concentration of the sintering accelerator contained in the oxygen-free atmosphere may be 1% by mass or more in terms of weight fraction.

Even in a case where the second copper paste for bonding contains a reductant, the second copper paste for bonding can be sintered in the same condition as described above.

The highest attainable temperature and the retention time of the highest attainable temperature when performing the heating treatment can be the same as those in the first sintering step described above.

### <Bonded Body and Semiconductor Device>

Hereinafter, preferred embodiments will be described in detail with reference to the drawings. Note that, in the drawings, the same reference numerals will be applied to the same or corresponding parts, and the repeated description will be omitted. In addition, a dimension ratio in the drawings is not limited to the illustrated ratio.

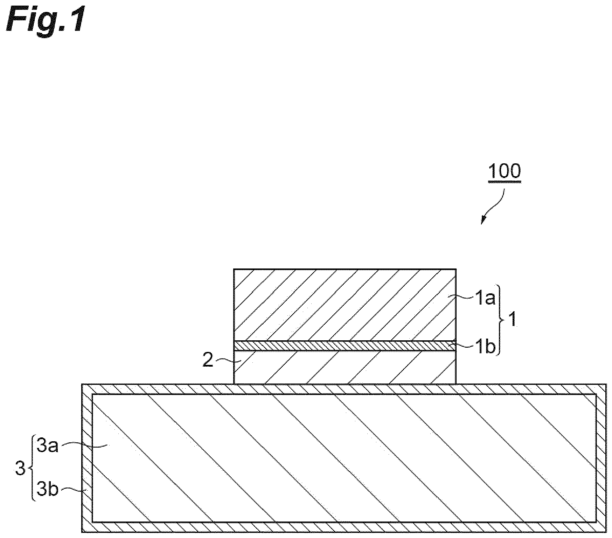

FIG. 1 is a schematic sectional view illustrating an example of a bonded body to be produced by using a metal paste for bonding. A bonded body 100 of this embodiment includes a first member 1 including a first base 1a and a first metal layer 1b, a second member 3 including a second base 3a and a second metal layer 3b, and a sintered body 2 for bonding the first member 1 and the second member 3.

Examples of the first member 1 and the second member 3 include the members described above. In addition, examples of the first metal layer 1b and the second metal layer 3b include the layers described above.

The sintered body 2 may be the sintered body of the metal paste for bonding according to this embodiment. In this case, the bonded body 100 can be obtained by the method for producing a bonded body according to this embodiment described above.

The die shear strength of the bonded body may be 10 MPa or more, may be 15 MPa or more, may be 20 MPa or more, or may be 30 MPa or more, from the viewpoint of sufficiently bonding the first member and the second member. The die shear strength can be measured by using a multi-purpose bondtester (4000 Series, manufactured by DAGE), or the like.

The thermal conductivity of the sintered body may be 100 W/(m·K) or more, may be 120 W/(m·K) or more, or may be 150 W/(m·K) or more, from the viewpoint of heat dissipation and connection reliability at a high temperature. The thermal conductivity can be calculated from the thermal diffusivity, the specific heat capacity, and the density of the sintered body of the metal paste for bonding.

In the bonded body described above, at least one of the first member and the second member may be a semiconductor element. Examples of the semiconductor element include a power module consisting of a diode, a rectifier, a thyristor, a MOS gate driver, a power switch, a power MOSFET, IGBT, a Schottky diode, a fast recovery diode, and the like, a transmitter, an amplifier, a LED module, and the like. In such a case, the bonded body is a semiconductor device. The semiconductor device to be obtained may have sufficient die shear strength and connection reliability.

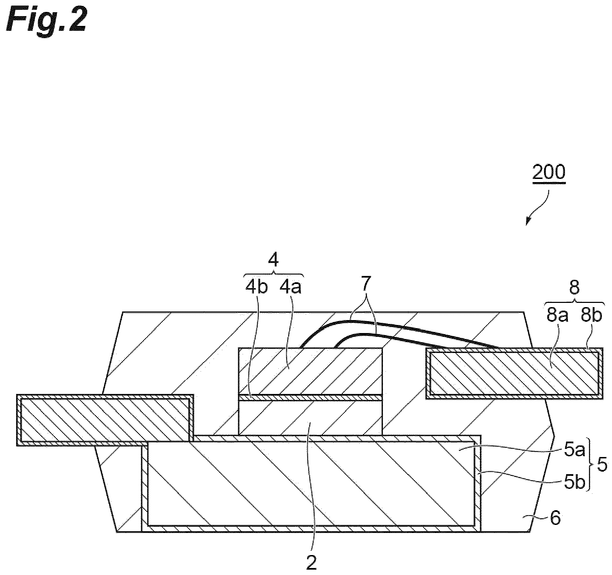

FIG. 2 is a schematic sectional view illustrating an example of a semiconductor device to be produced by using a metal paste for bonding. A semiconductor device 200 illustrated in FIG. 2 includes a semiconductor element 4 including a metal layer 4b and a base 4a, which is connected onto a lead frame 5 including a metal layer 5b and a base 5a via the sintered body 2 of the copper paste for bonding, and a mold resin 6 for molding the above. The semiconductor element 4 is connected to a lead frame 8 including a metal layer 8b and a base 8a via a wire 7.

Examples of the semiconductor device include a power module consisting of a diode, a rectifier, a thyristor, a MOS gate driver, a power switch, a power MOSFET, IGBT, a Schottky diode, a fast recovery diode, and the like, a transmitter, an amplifier, a high-brightness LED module, a semiconductor laser module, a logic, a sensor, and the like.

The semiconductor device can be produced as with the method for producing a bonded body according to this embodiment described above. That is, a method for producing the semiconductor device may include a step of preparing the laminated body in which the first member, the metal paste for bonding, and the second member are laminated in this order by using the semiconductor element in at least one of the first member and the second member, and a step of sintering the metal paste for bonding by heating the laminated body in a non-pressure condition in an oxygen-free atmosphere. The oxygen-free atmosphere may be an atmosphere not containing hydrogen or having a hydrogen concentration of 10% or less.

The metal paste for bonding may have the same composition as that of the metal paste for bonding according to this embodiment. The preparation of the laminated body and the sintering of the metal paste for bonding can be performed as with the laminated body preparing step and the sintering step described above.

The present disclosure may provide the invention described in the following [1] to [18].
[1] A metal paste for bonding, containing: metal particles; a dispersion medium; and a sintering accelerator, in which the metal particles contain copper particles, the sintering accelerator includes a coordinating compound having electron back donation properties, and the coordinating compound is at least one type selected from the group consisting of a nitrogen-containing aromatic heterocyclic compound, an acetylene derivative, an ethylene derivative, an organic arsenic compound, and a cyanide.
[2] The metal paste for bonding according to [1] described above, in which the coordinating compound has a lone electron pair and an empty π-electron orbit.
[3] The metal paste for bonding according to [1] described above, in which the coordinating compound is at least one type selected from the group consisting of 2,2'-bipyridyl, 1,10-phenanthroline, 1-ethyl imidazole, 3,6-dichloropyridazine, and 2-cyanopyrimidine.
[4] The metal paste for bonding according to any one of [1] to [3] described above, in which a content of the sintering accelerator is 0.01 parts by mass or more and 10 parts by mass or less with respect to a total mass of 100 parts by mass of the copper particles.
[5] The metal paste for bonding according to any one of [1] to [4] described above, in which the copper particles contain submicro-copper particles having a volume average particle size of 0.15 µm or more and 0.8 µm or less, and micro-copper particles having a volume average particle size of 2 µm or more and 50 µm or less, a sum of a content of the submicro-copper particles and a content of the micro-copper particles is 80% by mass or more, on the basis of a total mass of the metal particles, and the content of the submicro-copper particles is 30% by mass or more and 90% by mass or less, on the basis of a sum of a mass of the submicro-copper particles and a mass of the micro-copper particles.
[6] The metal paste for bonding according to [5] described above, in which the micro-copper particles are in the shape of a flake.
[7] The metal paste for bonding according to any one of [1] to [6] described above, further containing a reductant.
[8] A method for producing a bonded body, including: a step of preparing a laminated body in which a first member, the metal paste for bonding according to any one of [1] to [7] described above, and a second member are laminated in this order; and a sintering step of sintering the metal paste for bonding in the laminated body.
[9] The method for producing a bonded body according to [8] described above, in which in the sintering step, the metal paste for bonding is sintered in a non-pressure condition in an oxygen-free atmosphere.
[10] The method for producing a bonded body according to [8] or [9] described above, in which at least one of the first member and the second member is a semiconductor element.
[11] A method for producing a bonded body, including: a step of preparing a laminated body in which a first member, a metal paste for bonding containing metal particles and a dispersion medium, and a second member are laminated in this order; and a sintering step of sintering the metal paste for bonding in the laminated body in the presence of a sintering accelerator, in which the metal particles contain copper particles, the sintering accelerator includes a coordinating compound having electron back donation properties, and the coordinating compound is at least one type selected from the group consisting of carbon monoxide, ethylene, nitrogen monoxide, and hydrogen cyanide.
[12] The method for producing a bonded body according to [11] described above, in which in the sintering step, the metal paste for bonding is sintered in a non-pressure condition in an oxygen-free atmosphere.
[13] The method for producing a bonded body according to [11] or [12] described above, in which the metal paste for bonding further contains a reductant.
[14] The method for producing a bonded body according to any one of [11] to [13] described above, in which the copper particles contain submicro-copper particles having a volume average particle size of 0.15 µm or more and 0.8 µm or less, and micro-copper particles having a volume average particle size of 2 µm or more and 50 µm or less, a sum of a content of the submicro-copper particles and a content of the micro-copper particles in the metal paste for bonding is 80% by mass or more, on the basis of a total mass of the metal particles, and the content of the submicro-copper particles in the metal paste for bonding is 30% by mass or more and 90% by mass or less, on the basis of a sum of a mass of the submicro-copper particles and a mass of the micro-copper particles.
[15] The method for producing a bonded body according to [14] described above, in which the micro-copper particles are in the shape of a flake.
[16] The method for producing a bonded body according to any one of [11] to [15] described above, in which at least one of the first member and the second member is a semiconductor element.
[17] A bonded body, including: a first member; a second member; and a sintered body of the metal paste for bonding according to any one of [1] to [7] described above, which bonds the first member and the second member.
[18] A bonded body obtained by the method for producing a bonded body according to any one of [11] to [16] described above.

### Examples

Hereinafter, the present invention will be described in more detail on the basis of examples. However, the present invention is not limited to the following examples.

The measurement of each characteristic in each example and comparative example was implemented by the following method.

### (1) Die Shear Strength

The bonding strength of a bonded body was evaluated with a die shear strength between a silicon chip and a copper substrate bonded by a metal paste.

A metal paste was applied onto a copper plate (19 mm × 25 mm × 3 mm) by stencil printing using a metal mask in which nine square openings of 3 mm × 3 mm were provided in a stainless steel plate having a thickness of 200 µm, and a metal squeegee. A silicon chip (having an area of 3 mm × 3 mm, a thickness of 400 µm, and a copper-sputtered layer as an adherend surface (a bonding surface) with the metal paste) was placed on the applied metal paste, and lightly pressed with tweezers to obtain a laminated body. The laminated body was heated on a hot plate (manufactured by AS ONE CORPORATION, EC HOTPLATE EC-1200N) at 90°C for 60 minutes in the air. The laminated body was set in a fluxless reflow device (manufactured by Ayumi INDUSTRY CO., LTD.), the pressure was reduced to 1 Pa to remove the air, and then, nitrogen gas was introduced and replaced, and the laminated body was heated at 300°C for 1 hour while flowing nitrogen at 15 L/min at a normal pressure to obtain a bonded body in which the copper plate and the silicon chip were bonded by a copper sintered body. The bonded body was cooled and taken out in the air when the temperature was 50°C or lower.

The silicon chip of the obtained bonded body was pressed in a horizontal direction at measurement speed of 500 µm/s and a measurement height of 100 µm by using a multi-purpose bondtester (4000 Series, manufactured by DAGE) provided with 1 kN of a load cell to measure the die shear strength. The average value of the values obtained by measuring eight bonded bodies was set as the die shear strength.

Note that, the die shear strength of the bonded body obtained by bonding the silicon chip and the copper substrate with a lead solder was 20 MPa.

### (2) Bonded Section of Sintered Copper

The bonded body prepared in "(1) Die Shear Strength" described above was fixed with a sample clip (Samplklip I, manufactured by Buehler Ltd.) in a cup, an epoxy casting resin (Epomount, manufactured by Refine Tec Ltd.) was poured around the bonded body until the entire bonded body was filled and left to stand in a vacuum desiccator, and the pressure was reduced for 1 minute to remove the foam. After that, the epoxy casting resin was left to stand at a room temperature for 10 hours to be cured, and a sample was prepared. The sample was cut in the vicinity of the silicon chip by using Refine Saw Excel (manufactured by Refine Tec Ltd.). The bonded body was cut to the vicinity of the center by a polisher (Refine Polisher HV, manufactured by Refine Tec Ltd.) provided with water resistant abrasive paper (CARBOMAC PAPER, manufactured by Refine Tec Ltd.) to obtain the sectional surface. The sectional surface was subjected to flat milling processing (IM4000 manufactured by Hitachi High-Tech Co., Ltd.) using Ar ions. The bonded section of the copper sintered body was observed with a scanning electron microscope (Schottky FE-SEM SU5000, manufactured by Hitachi High-Tech Co., Ltd.).

### [Preparation of Metal Paste for Bonding]

Each metal paste for bonding having a preparation amount (parts by mass) shown in Table 1 was prepared in the following procedure. Note that, the preparation amount represented in the table is a ratio (parts by mass) of each component when the total mass of copper particles contained in the metal paste for bonding was set to 100 parts by mass (the sum of 100 parts by mass of submicro-copper particles and micro-copper particles). In addition, in a case where a sintering accelerator was in the shape of a lump or a pellet, the sintering accelerator was used by being pulverized with a planetary ball mill into a fine powder.

### (Example A-1)

99 g of dihydroterpineol (manufactured by Nippon Terpene Chemicals, Inc.) as a dispersion medium and 1000 g of CH-0200 (manufactured by MITSUI MINING & SMELTING CO., LTD., Product Name, a 50% volume average particle size of 0.36 µm by a laser scattering method) as submicro-copper particles were mixed, and stirred with a planetary mixer (manufactured by PRIMIX Corporation) at a rotation frequency of 300 rpm for 30 minutes. A mixture obtained was subjected once to a dispersion treatment with a disperizer (manufactured by SINTOKOGIO, LTD.) in the condition of a gap 50 µm and a rotation frequency of 12000 rpm to obtain a dispersion liquid of 91% by mass.

0.169 g of dihydroterpineol (manufactured by Nippon Terpene Chemicals, Inc.) as the residue of the dispersion medium, 0.240 g of tetraethylene glycol (hereinafter, abbreviated as TEG) (manufactured by FUJIFILM Wako Pure Chemical Corporation) as a reductant, 0.300 g of polyethylene glycol 300 (hereinafter, abbreviated as PEG300) (manufactured by FUJIFILM Wako Pure Chemical Corporation) and 0.300 g of polyethylene glycol 400 (hereinafter, abbreviated as PEG400) (manufactured by FUJIFILM Wako Pure Chemical Corporation) as a polyol-based compound, 0.173 g of 2,2'-bipyridyl (manufactured by FUJIFILM Wako Pure Chemical Corporation) as a sintering accelerator, 13.538 g of the dispersion liquid of 91% by mass obtained as described above, and 5.280 g of 2L3N (manufactured by FUKUDA METAL FOIL & POWDER CO., LTD., Product Name, a 50% volume average particle size of 9.9 µm by a laser scattering method) as micro-copper particles were mixed, and stirred with a rotary and revolutionary mixer (manufactured by THINKY CORPORATION, Awatori Rentaro ARE-310) at 2000 rpm for 3 minutes under a reduced pressure to obtain a metal paste for bonding.

### (Example A-2)

A metal paste for bonding was obtained as with Example A-1, except that the sintering accelerator was changed to 1,10-phenanthroline (manufactured by Sigma-Aldrich Chemistry) instead of 2,2'-bipyridyl.

### (Comparative Example A-1 to Comparative Example A-6)

Each metal paste for bonding was obtained as with Example A-1, except that the sintering accelerator was changed to a dimethyl glutaric acid, a nitrilotriacetic acid, an ascorbic acid, triethanol amine, diethyl tartrate, or glycine instead of 2,2'-bipyridyl, as shown in Table 1.

### (Comparative Example A-7)

A metal paste for bonding was obtained as with Example A-1, except that the sintering accelerator was not compounded, and the preparation amount of the dispersion medium was changed to a ratio shown in Table 1.

### [Evaluation of Metal Paste for Bonding]

Bonded bodies were prepared by using the metal pastes for bonding obtained in the examples and the comparative examples, in accordance with the method described in (1) Die Shear Strength, and the bonding strength thereof was evaluated. Results are shown in the table.

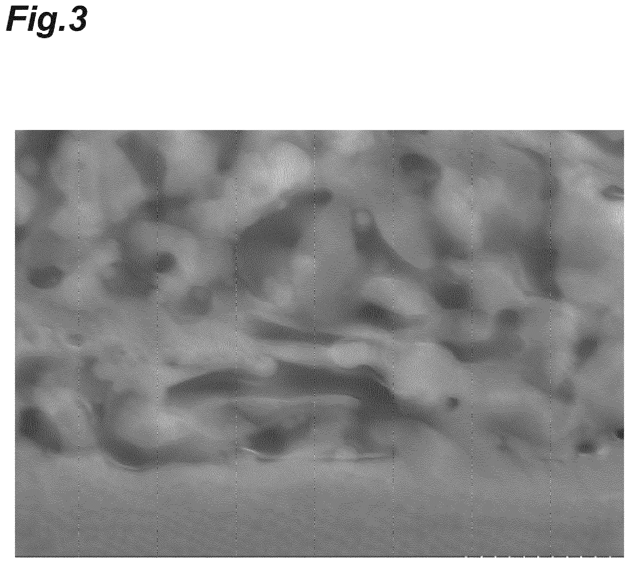

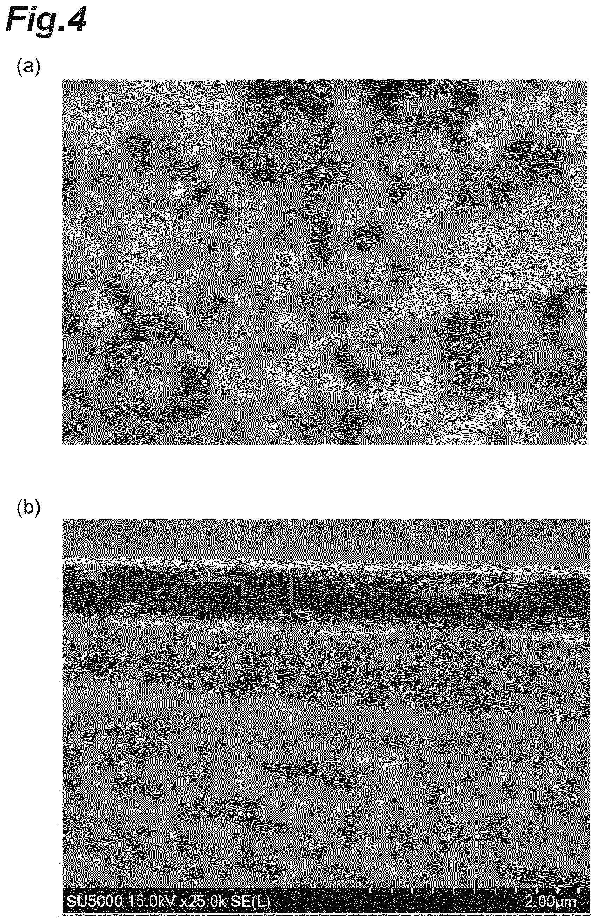

For the prepared bonded body, the bonded section of the copper sintered body was observed in accordance with the method described in (2) Bonded Section of Sintered Copper. FIG. 3 is a SEM image illustrating the bonded section of the copper sintered body in the bonded body prepared by using the metal paste for bonding of Example A-1, and FIG. 4 is a SEM image illustrating the bonded section of the copper sintered body in the bonded body prepared by using the metal paste for bonding of Comparative Example A-7. As illustrated in FIG. 3, in the bonded body obtained by using the metal paste for bonding of Example A-1, the copper particles are sintered together to form a network-like structure. In addition, such a network structure is integrated with the surface of the adherend (the copper substrate) at the bottom of the picture, and it was determined that bonding is formed. On the other hand, as illustrated in FIG. 4(a), in the bonded body obtained by using the metal paste for bonding of Comparative Example A-7, since the shape of the raw material particles remain as it is, the particles are not sintered, and the network structure is not also formed. Therefore, as illustrated in FIG. 4(b), sites where bonding is not formed were observed at the interface on the chip side.

**[Table 1]**

| | | Exampl e A-1 | Exampl e A-2 | Comparativ e Example A-1 | Comparativ e Example A-2 | Comparativ e Example A-3 | Comparativ e Example A-4 | Comparativ e Example A-5 | Comparativ e Example A-6 | Comparativ e Example A-7 |
|---|---|---|---|---|---|---|---|---|---|---|
| Dispersion medium | Dihydroterpineol | 7.88 | 7.88 | 7.88 | 7.88 | 7.88 | 7.88 | 7.88 | 7.88 | 8.86 |
| Reductant | TEG | 1.36 | 1.36 | 1.36 | 1.36 | 1.36 | 1.36 | 1.36 | 1.36 | 1.36 |
| | PEG300 | 1.70 | 1.70 | 1.70 | 1.70 | 1.70 | 1.70 | 1.70 | 1.70 | 1.70 |
| | PEG400 | 1.70 | 1.70 | 1.70 | 1.70 | 1.70 | 1.70 | 1.70 | 1.70 | 1.70 |
| Sintering accelerator | 2,2'-Bipyridyl | 0.98 | - | - | - | - | - | - | - | - |
| | 1,10-Phenanthroline | - | 0.98 | - | - | - | - | - | - | - |
| | Dimethyl glutaric acid | - | - | 0.98 | - | - | - | - | - | - |
| | Nitrilotriacetic acid | - | - | - | 0.98 | - | - | - | - | - |
| | Ascorbic acid | - | - | - | - | 0.98 | - | - | - | - |
| | Triethanol amine | - | - | - | - | - | 0.98 | - | - | - |
| | Diethyl tartrate | - | - | - | - | - | - | 0.98 | - | - |
| | Glycine | - | - | - | - | - | - | - | 0.98 | - |
| Submicro-copper particles | CH-0200 | 70 | 70 | 70 | 70 | 70 | 70 | 70 | 70 | 70 |
| Micro-copper particles | 2L3N | 30 | 30 | 30 | 30 | 30 | 30 | 30 | 30 | 30 |
| Total mass (parts by mass) of copper particles | | 100 | 100 | 100 | 100 | 100 | 100 | 100 | 100 | 100 |
| Bonding condition (in nitrogen atmosphere) | Impressed pressure (MPa) | 0 | 0 | 0 | 0 | 0 | 0 | 0 | 0 | 0 |
| | Temperature (°C) | 300 | 300 | 300 | 300 | 300 | 300 | 300 | 300 | 300 |
| | Time (minutes) | 60 | 60 | 60 | 60 | 60 | 60 | 60 | 60 | 60 |
| Die shear strength (MPa) | | 45 | 44 | 17 | 13 | 4 | 2 | 0 | 0 | 0 |

### (Example B-1)

98.9 g of dihydroterpineol (manufactured by Nippon Terpene Chemicals, Inc.) as a dispersion medium and 1000 g of CH-0200 (manufactured by MITSUI MINING & SMELTING CO., LTD., Product Name, a 50% volume average particle size of 0.36 µm by a laser scattering method) as submicro-copper particles were mixed, and stirred with a planetary mixer (manufactured by PRIMIX Corporation) at a rotation frequency of 300 rpm for 30 minutes. A mixture obtained was subjected once to a dispersion treatment with a disperizer (manufactured by SINTOKOGIO, LTD.) in the condition of a gap of 50 µm and a rotation frequency of 12000 rpm to obtain a dispersion liquid of 91% by mass.

0.158 g of dihydroterpineol (manufactured by Nippon Terpene Chemicals, Inc.) as the residue of the dispersion medium, 0.120 g of tetraethylene glycol (hereinafter, abbreviated as TEG) (manufactured by FUJIFILM Wako Pure Chemical Corporation) as a reductant, 0.180 g of polyethylene glycol 300 (hereinafter, abbreviated as PEG300) (manufactured by FUJIFILM Wako Pure Chemical Corporation) and 0.120 g of polyethylene glycol 400 (hereinafter, abbreviated as PEG400) (manufactured by FUJIFILM Wako Pure Chemical Corporation) as a polyol-based compound, 0.048 g of 2,2'-bipyridyl (manufactured by FUJIFILM Wako Pure Chemical Corporation) as a sintering accelerator, 6.382 g of the dispersion liquid of 91% by mass obtained as described above, and 2.728 g of 2L3N (manufactured by FUKUDA METAL FOIL & POWDER CO., LTD., Product Name, a 50% volume average particle size of 9.9 µm by a laser scattering method) and C3 (manufactured by FUKUDA METAL FOIL & POWDER CO., LTD., Product Name, a 50% volume average particle size of 37 µm by a laser scattering method) as micro-copper particles were mixed, and stirred with a rotary and revolutionary mixer (manufactured by THINKY CORPORATION, Awatori Rentaro ARE-310) at 2000 rpm for 3 minutes under a reduced pressure to obtain a metal paste for bonding.

### (Example B-2 to Example B-4)

Each metal paste for bonding was obtained as with Example B-1, except that the preparation amount of the dispersion medium and the sintering accelerator was changed to a ratio shown in Table 2 (the mass of the sintering accelerator was 0.55 parts by mass, 0.98 parts by mass, 1.64 parts by mass, or 2.05 parts by mass, with respect to the total mass of 100 parts by mass of the copper particles).

### (Example B-5)

Each metal paste for bonding was obtained as with Example B-1, except that the preparation amount of the dispersion medium, the reductant, and the sintering accelerator was changed to a ratio shown in Table 2 (the mass of the reductant was 4.37 parts by mass and the mass of the sintering accelerator was 2.73 parts by mass, with respect to the total mass of 100 parts by mass of the copper particles).

### (Comparative Example B-1)

A metal paste for bonding was obtained as with Example B-1, except that the sintering accelerator was not compounded, and the preparation amount of the dispersion medium was changed to a ratio shown in Table 2.

**[Table 2]**

| | | Example B-1 | Example B-2 | Example B-3 | Example B-4 | Example B-5 | Comparative Example B-1 |
|---|---|---|---|---|---|---|---|
| Dispersion medium | Dihydroterpineol | 8.31 | 7.88 | 7.23 | 6.82 | 6.55 | 8.86 |
| Reductant | TEG | 1.36 | 1.36 | 1.36 | 1.36 | 0.96 | 1.36 |
| | PEG300 | 2.05 | 2.05 | 2.05 | 2.05 | 2.05 | 2.05 |
| | PEG400 | 1.36 | 1.36 | 1.36 | 1.36 | 1.36 | 1.36 |
| Sintering accelerator | 2,2'-Bipyridyl | 0.55 | 0.98 | 0.98 | 2.05 | 2.73 | - |
| Submicro-copper particles | CH-0200 | 66 | 66 | 66 | 66 | 66 | 66 |
| Micro-copper particles | 2L3N | 31 | 31 | 31 | 31 | 31 | 31 |
| | C3 | 3 | 3 | 3 | 3 | 3 | 3 |
| Total mass (parts by mass) of copper particles | | 100 | 100 | 100 | 100 | 100 | 100 |
| Bonding condition (in nitrogen atmosphere) | Impressed pressure (MPa) | 0 | 0 | 0 | 0 | 0 | 0 |
| | Temperature (°C) | 300 | 300 | 300 | 300 | 300 | 300 |
| | Time (minutes) | 60 | 60 | 60 | 60 | 60 | 60 |
| Die shear strength (MPa) | | 29 | 45 | 50 | 32 | 29 | 13 |

### (Example B-6 to Example B-8)

Each metal paste for bonding was obtained as with Example B-1, except that the sintering accelerator was changed to 1,10-phenanthroline (manufactured by Sigma-Aldrich Chemistry) instead of 2,2'-bipyridyl, and the preparation amount of the dispersion medium and the sintering accelerator (the dispersion medium in Example B-8) was changed to a ratio shown in Table 3 (the mass of the sintering accelerator was 0.068 parts by mass, 0.27 parts by mass, or 0.55 parts by mass, with respect to the total mass of 100 parts by mass of the copper particles).

### (Example B-9 to Example B-10)

Each metal paste for bonding was obtained as with Example B-1, except that the sintering accelerator was changed to 1-ethyl imidazole (manufactured by FUJIFILM Wako Pure Chemical Corporation) instead of 2,2'-bipyridyl, and the preparation amount of the dispersion medium and the sintering accelerator was changed to a ratio shown in Table 3 (the mass of the sintering accelerator was 0.014 parts by mass or 0.068 parts by mass, with respect to the total mass of 100 parts by mass of the copper particles).

### (Example B-11 to Example B-17)

Each metal paste for bonding was obtained as with Example B-1, except that the sintering accelerator was changed to 3,6-dichloropyridazine (manufactured by FUJIFILM Wako Pure Chemical Corporation) instead of 2,2'-bipyridyl, and the preparation amount of the dispersion medium and the sintering accelerator (the dispersion medium in Example B-15) was changed to a ratio shown in Table 4 (the mass of the sintering accelerator was 0.014 parts by mass, 0.068 parts by mass, 0.14 parts by mass, 0.27 parts by mass, 0.55 parts by mass, 0.98 parts by mass, or 1.64 parts by mass, with respect to the total mass of 100 parts by mass of the copper particles).

### (Example B-18 to Example B-21)

Each metal paste for bonding was obtained as with Example B-1, except that the sintering accelerator was changed to 2-cyanopyrimidine (manufactured by Tokyo Chemical Industry Co., Ltd.) instead of 2,2'-bipyridyl, and the preparation amount of the dispersion medium and the sintering accelerator was changed to a ratio shown in Table 5 (the mass of the sintering accelerator was 0.014 parts by mass, 0.068 parts by mass, 0.14 parts by mass, or 0.27 parts by mass, with respect to the total mass of 100 parts by mass of the copper particles).

### [Evaluation of Metal Paste for Bonding]

Bonded bodies were prepared by using the metal pastes for bonding obtained in the examples and the comparative examples, in accordance with the method described in (1) Die Shear Strength, and the bonding strength thereof was evaluated. Results are shown in the table.

**[Table 3]**

| | | Example B-6 | Example B-7 | Example B-8 | Example B-9 | Example B-10 |
|---|---|---|---|---|---|---|
| Dispersion medium | Dihydroterpineol | 8.8 | 8.59 | 8.32 | 8.85 | 8.8 |
| Reductant | TEG | 1.36 | 1.36 | 1.36 | 1.36 | 1.36 |
| | PEG300 | 2.05 | 2.05 | 2.05 | 2.05 | 2.05 |
| | PEG400 | 1.36 | 1.36 | 1.36 | 1.36 | 1.36 |
| Sintering accelerator | 1,10-Phenanthroline | 0.068 | 0.27 | 0.55 | - | - |
| | 1-Ethyl imidazole | - | - | - | 0.014 | 0.068 |
| Submicro-copper particles | CH-0200 | 66 | 66 | 66 | 66 | 66 |
| Micro-copper particles | 2L3N | 31 | 31 | 31 | 31 | 31 |
| | C3 | 3 | 3 | 3 | 3 | 3 |
| Total mass (parts by mass) of copper particles | | 100 | 100 | 100 | 100 | 100 |
| Bonding condition (in nitrogen atmosphere) | Impressed pressure (MPa) | 0 | 0 | 0 | 0 | 0 |
| | Temperature (°C) | 300 | 300 | 300 | 300 | 300 |
| | Time (minutes) | 60 | 60 | 60 | 60 | 60 |
| Die shear strength (MPa) | | 32 | 44 | 36 | 18 | 22 |

**[Table 4]**

| | | Example B-11 | Example B-12 | Example B-13 | Example B-14 | Example B-15 | Example B-16 | Example B-17 |
|---|---|---|---|---|---|---|---|---|
| Dispersion medium | Dihydroterpineol | 8.85 | 8.8 | 8.73 | 8.59 | 8.32 | 7.88 | 7.23 |
| Reductant | TEG | 1.36 | 1.36 | 1.36 | 1.36 | 1.36 | 1.36 | 1.36 |
| | PEG300 | 2.05 | 2.05 | 2.05 | 2.05 | 2.05 | 2.05 | 2.05 |
| | PEG400 | 1.36 | 1.36 | 1.36 | 1.36 | 1.36 | 1.36 | 1.36 |
| Sintering accelerator | 3,6-Dichloropyridazine | 0.014 | 0.068 | 0.14 | 0.27 | 0.55 | 0.98 | 1.64 |
| Submicro-copper particles | CH-0200 | 66 | 66 | 66 | 66 | 66 | 66 | 66 |
| Micro-copper particles | 2L3N | 31 | 31 | 31 | 31 | 31 | 31 | 31 |
| | C3 | 3 | 3 | 3 | 3 | 3 | 3 | 3 |
| Total mass (parts by mass) of copper particles | | 100 | 100 | 100 | 100 | 100 | 100 | 100 |
| Bonding condition (in nitrogen atmosphere) | Impressed pressure (MPa) | 0 | 0 | 0 | 0 | 0 | 0 | 0 |
| | Temperature (°C) | 300 | 300 | 300 | 300 | 300 | 300 | 300 |
| | Time (minutes) | 60 | 60 | 60 | 60 | 60 | 60 | 60 |
| Die shear strength (MPa) | | 20 | 30 | 51 | 40 | 40 | 33 | 21 |

**[Table 5]**

| | | Example B-18 | Example B-19 | Example B-20 | Example B-21 |
|---|---|---|---|---|---|
| Dispersion medium | Dihydroterpineol | 8.85 | 8.8 | 8.73 | 8.59 |
| Reductant | TEG | 1.36 | 1.36 | 1.36 | 1.36 |
| | PEG300 | 2.05 | 2.05 | 2.05 | 2.05 |
| | PEG400 | 1.36 | 1.36 | 1.36 | 1.36 |
| Sintering accelerator | 2-Cyanopyrimidine | 0.014 | 0.068 | 0.14 | 0.27 |
| Submicro-copper particles | CH-0200 | 66 | 66 | 66 | 66 |
| Micro-copper particles | 2L3N | 31 | 31 | 31 | 31 |
| | C3 | 3 | 3 | 3 | 3 |
| Total mass (parts by mass) of copper particles | | 100 | 100 | 100 | 100 |
| Bonding condition (in nitrogen atmosphere) | Impressed pressure (MPa) | 0 | 0 | 0 | 0 |
| | Temperature (°C) | 300 | 300 | 300 | 300 |
| | | 60 | 60 | 60 | 60 |
| Die shear strength (MPa) | | 22 | 27 | 25 | 24 |

### Reference Signs List

1: first member, 1a: first base, 1b: first metal layer, 2: sintered body, 3: second member, 3a: second base, 3b: second metal layer, 4: semiconductor element, 4a: base of semiconductor element, 4b: metal layer of semiconductor element, 5: lead frame, 5a: base, 5b: metal layer, 6: mold resin, 7: wire, 8: lead frame, 8a: base, 8b: metal layer, 100: bonded body, 200: semiconductor device.

## Claims

1. A metal paste for bonding, comprising:
metal particles;
a dispersion medium; and
a sintering accelerator,
wherein the metal particles contain copper particles, and
the sintering accelerator includes a coordinating compound having electron back donation properties, and the coordinating compound is at least one type selected from the group consisting of a nitrogen-containing aromatic heterocyclic compound, an acetylene derivative, an ethylene derivative, an organic arsenic compound, and a cyanide.

2. The metal paste for bonding according to claim 1, wherein the coordinating compound has a lone electron pair and an empty π-electron orbit.

3. The metal paste for bonding according to claim 1, wherein the coordinating compound is at least one type selected from the group consisting of 2,2'-bipyridyl, 1,10-phenanthroline, 1-ethyl imidazole, 3,6-dichloropyridazine, and 2-cyanopyrimidine.

4. The metal paste for bonding according to claim 1, wherein a content of the sintering accelerator is 0.01 parts by mass or more and 10 parts by mass or less with respect to a total mass of 100 parts by mass of the copper particles.

5. The metal paste for bonding according to claim 1,
wherein the copper particles contain submicro-copper particles having a volume average particle size of 0.15 µm or more and 0.8 µm or less, and micro-copper particles having a volume average particle size of 2 µm or more and 50 µm or less,
a sum of a content of the submicro-copper particles and a content of the micro-copper particles is 80% by mass or more, on the basis of a total mass of the metal particles, and
the content of the submicro-copper particles is 30% by mass or more and 90% by mass or less, on the basis of a sum of a mass of the submicro-copper particles and a mass of the micro-copper particles.

6. The metal paste for bonding according to claim 5, wherein the micro-copper particles are in the shape of a flake.

7. The metal paste for bonding according to claim 1, further comprising a reductant.

8. A method for producing a bonded body, comprising:
a step of preparing a laminated body in which a first member, the metal paste for bonding according to any one of claims 1 to 7, and a second member are laminated in this order; and
a sintering step of sintering the metal paste for bonding in the laminated body.

9. The method for producing a bonded body according to claim 8, wherein in the sintering step, the metal paste for bonding is sintered in a non-pressure condition in an oxygen-free atmosphere.

10. The method for producing a bonded body according to claim 8, wherein at least one of the first member and the second member is a semiconductor element.

11. A method for producing a bonded body, comprising:
a step of preparing a laminated body in which a first member, a metal paste for bonding containing metal particles and a dispersion medium, and a second member are laminated in this order; and
a sintering step of sintering the metal paste for bonding in the laminated body in the presence of a sintering accelerator,
wherein the metal particles contain copper particles, and
the sintering accelerator includes a coordinating compound having electron back donation properties, and the coordinating compound is at least one type selected from the group consisting of carbon monoxide, ethylene, nitrogen monoxide, and hydrogen cyanide.

12. The method for producing a bonded body according to claim 11, wherein in the sintering step, the metal paste for bonding is sintered in a non-pressure condition in an oxygen-free atmosphere.

13. The method for producing a bonded body according to claim 11, wherein the metal paste for bonding further contains a reductant.

14. The method for producing a bonded body according to claim 11,
wherein the copper particles contain submicro-copper particles having a volume average particle size of 0.15 µm or more and 0.8 µm or less, and micro-copper particles having a volume average particle size of 2 µm or more and 50 µm or less,
a sum of a content of the submicro-copper particles and a content of the micro-copper particles in the metal paste for bonding is 80% by mass or more, on the basis of a total mass of the metal particles, and
the content of the submicro-copper particles in the metal paste for bonding is 30% by mass or more and 90% by mass or less, on the basis of a sum of a mass of the submicro-copper particles and a mass of the micro-copper particles.

15. The method for producing a bonded body according to claim 14, wherein the micro-copper particles are in the shape of a flake.

16. The method for producing a bonded body according to claim 11, wherein at least one of the first member and the second member is a semiconductor element.

17. A bonded body, comprising:
a first member;
a second member; and
a sintered body of the metal paste for bonding according to any one of claims 1 to 7, which bonds the first member and the second member.

18. A bonded body obtained by the method for producing a bonded body according to any one of claims 11 to 16.
